# EUROPÄISCHE PATENTSCHRIFT

(11) **EP 0 733 129 B1**
(45) Veröffentlichungstag und Bekanntmachung des Hinweises auf die Patenterteilung: **29.07.1998**
(21) Anmeldenummer: 93906570.2
(22) Anmeldetag: 19.03.1993
(51) Int. Cl.: C23C 4/08, C04B 41/88

(54) **VERFAHREN ZUR HERSTELLUNG EINES HAFTFESTEN VERBUNDES ZWISCHEN KUPFERSCHICHTEN UND KERAMIK**
PROCESS FOR PRODUCING AND ADHESIVE BOND BETWEEN COPPER LAYERS AND CERAMICS
PROCEDE POUR LA FABRICATION D'UN MELANGE ADHERENT ENTRE DES COUCHES DE CUIVRE ET DE LA CERAMIQUE

(30) Priorität: 02.04.1992 DE 4210900
(43) Veröffentlichungstag der Anmeldung: 25.09.1996
(73) Patentinhaber: HOECHST AKTIENGESELLSCHAFT, 65926 Frankfurt am Main (DE)
(72) Erfinder: KÜHN, Heinrich, D-6259 Brechen (DE); BOS, Ulrich, D-6203 Hochheim am Main (DE); HANNSS, Carsten, D-8255 Nossen (DE); VON KAYSER, Karl-Friedrich, D-6229 Schlangenbad (DE)
(86) Internationale Anmeldenummer: EP9300675
(87) Internationale Veröffentlichungsnummer: WO9320255

(56) Entgegenhaltungen:
- CH-A- 667 106
- DE-A- 3 509 022
- DE-C- 3 038 976
- Soviet Patents Abstracts, Sektion CH, Woche 9148, erschienen 22. JUnner 1992,
- Derwent Publications LDT., London, M13, AS SIBE THEORE- TICAL "Coating of metals and alloys with powders- -using high velocity gas powder stream with improved efficiency and productivity", Metallurgy, Seite 18, die Zusammenfassung-Nr. SU-A-1618 778.

## Beschreibung

Die Erfindung betrifft ein Verfahren zur Herstellung eines haftfesten Verbundes zwischen Kupferschichten, die mittels thermischer Spritztechnik von pulverförmigem Kupfer oder Kupferlegierungen aufgebracht sind, und Keramik.

Auf dem Gebiet der elektronischen Bauelemente ist die Verbindung von Kupfer als elektrisch sehr gut leitendem Metall mit Oxidkeramik als gut wärmeleitendem Isolator von besonderer technischer Bedeutung. Die Kupferschicht findet Verwendung als Leiterbahnschicht, Elektrodenschicht, Sensorschicht oder auch als Verbindungsschicht beim Anlöten der Oxidkeramik als Kühlkörper, sogenanntem "Heatsink", an andere in besonders hohem Maße Wärme entwickelnde Bauteile.

Für das direkte Aufbingen von Kupfer auf Keramik sind bereits verschiedene Verfahren bekannt. Die DE-A-38 24 249 beschreibt z.B. die außenstromlose Abscheidung nach vorheriger Aufrauhung der Keramikoberfläche und die anschliessende Palladiumbekeimung mit nachfolgender Wärmebehandlung. Nachteiligerweise läßt dieses Verfahren nur Metallschichten mit einer maximalen Schichtdicke von bis zu 5 µm zu.

Die DE-A-30 36 128 beschreibt das sogenannte Direct-Copper-Bonding Verfahren (DCB), bei dem ein 100 bis 900 µm dickes Kupferblech bei einer Temperatur von etwa 1070 °C auf die Keramikoberfläche aufgebracht wird. Das DCB-Verfahren ist allerdings nur dann wirtschaftlich, wenn Schichten mit Schichtdicken von mehr als 100 µm aufgetragen werden sollen.

Die CH-A- 667 106 offenbart ein Verfahren zur Herstellung einer haftfesten Verbundes zwischen Kupferschichten und Glas durch Plasmaspritzen oder Flammspritzen. Angaben zum Teilchendurchmessers des Kupferpulvers sind der Schrift nicht zu entnehmen.

Eine Grundmetallisierung durch Kathodenzerstäubung im Vakuum oder gemäß DE-A-38 24 249 und anschließender galvanischer Abscheidung von Kupfer läßt sich wirtschaftlich höchstens bis zu einer Schichtdicke von 50 µm durchführen. Die Haftfestigkeit der aufgetragenen Schicht auf dem Keramikmaterial läßt sich im Falle der Kathodenzerstäubung durch eine sogenannte Haftvermittlerschicht aus Chrom, Titan u.a. steigern, jedoch führt diese Haftvermittlerschicht zu erheblichen Nachteilen bei der Weiterverarbeitung der Leiterbahnen durch Ätzen.

Die sputtertechnische Aufbringung von Kupfer in einer Vakuumkammer mit vorherigem Plasmaätzprozeß in der gleichen Vakuumkammer ist wirtschaftlich nur bis zu einer Schichtdicke von 1 bis 2 µm möglich.

In der thermischen Spritztechnik ist bekannt, daß Kupfer sowohl auf metallische als auch auf nichtmetallische Werkstoffe aufgetragen werden kann. Anwendungen derartiger Auftragungen sind die Verbesserung des Übergangswiderstandes oder das Anbringen von lötbaren Verbindungen u.ä. an den Werkstoffen. Die so aufgebrachten Schichten haben auf Grund der Oxidation des Kupfers während des Auftragvorganges im Vergleich zu reinem Elektrolytkupfer einen hohen elektrischen Widerstand. Die verschiedenen thermischen Spritzprozesse unter Vakuum beziehungsweise in Schutzgaskammern sind in technischer Hinsicht sehr aufwendig und bezogen auf die Bauteilgeometrie der elektronischen Bauelemente in einer Massenfertigung wirtschaftlich kaum anwendbar.

Darüber hinaus ist die außerordentlich hohe Maßhaltigkeit der in der modernen Hochleistungstechnik benötigten Oberflächengeometrie nur durch aufwendige mechanische Nachbearbeitung bei den bekannten Verfahrensschritten möglich, bei bestimmten Teilen läßt sie sich gar nicht realisieren.

Aufgabe der Erfindung war es daher, Kupfer oder Kupferlegierungen durch thermisches Spritzen so auf keramische Bauelemente aufzubringen, daß mit einem einfachen Verfahren ausreichend haftfeste Schichten mit einer beliebigen Schichtdicke im breiten Bereich von 5 µm - 300 pm mit einer elektrischen Leitfähigkeit nahe derjenigen des Elektrolytkupfers hergestellt werden können, die zusätzlich gleichzeitig eine niedrige Dickenschwankung ihrer Schichtdicke zeigen.

Gelöst wird diese Aufgabe durch ein Verfahren der eingangs genannten Gattung, dessen kennzeichnendes Merkmal darin zu sehen ist, daß auf die keramische Oberfläche feinkörniges Kupferpulver mit einem mittleren Teilchendurchmesser von ≤ 20 pm durch thermisches Spritzen aufgetragen wird.

Als keramisches Material haben sich insbesondere oxidkeramische Materialien wie Aluminiumoxid, Berylliumoxid oder Zirkoniumoxid erfindungsgemäß bewährt, es können aber sehr vorteilhaft auch nichtoxidische Keramikmaterialien wie beispielsweise Aluminiumnitrid in Frage kommen. Nach einer besonders zweckmäßigen Ausgestaltung des erfindungsgemäßen Verfahrens wird die keramische Oberfläche zunächst einem Aufrauhprozeß unterzogen, ohne daß deren Oberflächengeometrie stark verändert wird. Vorzugsweise wird die Oberfläche von Aluminiumoxidsubstraten mit einem Reinheitsgrad im Bereich von 90 bis 100 % (Aluminiumoxid) mit Mineralsäuren behandelt, insbesondere mit einem Gemisch enthaltend Schwefelsäure und Phosphorsäure im Mischungsverhältnis von 1:1 über eine Zeitdauer von etwa 45 Minuten bei einer Temperatur von wenigstens etwa 180 °C, vorzugsweise im Bereich von 220 bis 260 °C. Danach wird die Oberfläche mit Wasser gespült und anschließend bei 150 bis 200 °C im Umluftofen getrocknet. Die Zeitdauer der Trocknung beträgt einige Stunden, vorzugsweise wenigstens 24 Stunden. Die Oberflächenrauheit R_{z} von auf diese Weise behandelten Aluminiumoxidsubstraten liegt im Bereich von 2 bis 5 µm, gemessen nach DIN 4768.

Alternativ kann die keramische Oberfläche zur Vorbereitung auf die Auftragung der Kupferschicht anstatt mit Mineralsäuren mit einem Sandstrahlverfahren behandelt werden. Vorzugsweise kann hierzu eine Aufrauhung der Oberfläche mit Sandstrahlgeräten vorgesehen sein, wobei als Strahlmittel vorzugsweise mineralisches Strahlgut wie feinkörniges Siliciumcarbid, Aluminiumoxid, u. a. in Frage kommen. Erfindungsgemäß bevorzugte Strahlbedingungen sind ein Strahldruck im Bereich von 4 bis 6 bar, eine Korngröße im Bereich von 10 bis 80 µm, ein Abstand der Düse zu der zu behandelnden Oberfläche im Bereich von 100 bis 150 mm und eine Bewegung der Düse über die behandelte Oberfläche hinweg mit einer Geschwindigkeit im Bereich von 0,5 bis 1 m/sec.

Zweckmäßigerweise folgt dem alternativen Aufrauhprozeß ein Reinigungsprozeß, der beispielsweise mit Unterstützung durch Ultraschall in einem alkoholischen Bad, vorzugsweise in Isopropanol, oder alternativ in heißer Schwefelsäure bei einer Temperatur im Bereich von 140 bis 160 °C abgewickelt wird. Durch den Reinigungsprozess wird im Rahmen der Erfindung sichergestellt, daß eventuell noch vorhandene Verunreingungen an der Oberfläche wirksam entfernt werden. Nach Trocknung der gereinigten Oberfläche bei Temperaturen im Bereich von 150 bis 200 °C im Umluftofen können solche Oberflächen ebenfalls erfindungsgemäß beschichtet werden.

Das Auftragen von Kupfer und Kupferlegierungen erfolgt erfindungsgemäß durch thermisches Spritzen von pulverförmigem Werkstoff. Erfindungsgemäß kommen vorzugsweise das Plasmaspritzen und das Hochgeschwindigkeitsflammspritzen zum Einsatz. Die Beschaffenheit des Pulvers wird auf die unterschiedlichen thermischen Spritzverfahren und den Verwendungszweck abgestimmt. Das Kupferpulver hat erfindungsgemäß bevorzugt eine Korngröße d₅₀ im Bereich von 8 bis 12 µm, die nach der Analysenmethode Laserbeugung Silas bestimmt wird. Das Kupfer oder die Kupferlegierung hat zweckmäßigerweise eine Reinheit von mindestens 99 %, bezogen auf solche Bestandteile, die die elektrische Leitfähigkeit negativ beeinflussen. Als Legierungsbestandteile können dem Kupfer Edelmetalle wie Silber, Gold oder Palladium in Mengen bis zu 30 % zulegiert sein. Der Phosphorgehalt des Kupfers oder der Kupferlegierung liegt im Bereich von 0,08 bis 0,15 % und wird fotometrisch bestimmt während der Sauerstoffgehalt im Bereich von 0,2 bis 0,3 % liegt und durch Heißextraktion im Inertgasstrom bestimmt wird. Überraschend zeigte sich, daß ein Phosphorgehalt von vorzugsweise 0,10 bis 0,12 % für die elektrische Leitfähigkeit nicht störend ist, sondern im Gegenteil positive Auswirkungen auf das Oxidationsverhalten der aufgetragenen Kupferschicht ausübt.

Bei dem Plasmaspritzverfahren wird als Plasmagas ein Inertgas wie Stickstoff, Wasserstoff oder ein Edelgas und/oder deren Mischungen verwendet, vorzugsweise Argon in einer Menge im Bereich von 30 bis 60 l/min. Die elektrische Leistung des Plasmabrenners beträgt bevorzugt 10 bis 15 kW, besonders bevorzugt 12 kW, wobei der Brenner in einem Abstand im Bereich von 40 bis 100 mm, vorzugsweise von 40 bis 70 mm, mit einer Geschwindigkeit von 10 bis 100 m/min über das zur Beschichtung vorgesehene Substrat hinwegbewegt wird. Unter derartigen Bedingungen wird erfindungsgemäß eine Auftragsrate im Bereich von 2 bis 8 kg/h erreicht.

Die zur Beschichtung vorgesehenen keramischen Bauteile werden während des Beschichtungsvorganges, um die Oxidbildung geringzuhalten und um Eigenspannungen sowohl in der Beschichtung, als auch im Beschichtungskörper vorzubeugen, vorzugsweise gekühlt. Zu diesem Zweck wird bevorzugt CO₂ in fein kristalliner oder flüssiger Form bei einem hohen Druck von circa 40 bis 60 bar eingesetzt. Es ist zwar bekannt, daß CO₂ flüssig zur Kühlung beim thermischen Spritzen Verwendung findet, jedoch ist es für den Fachmann überraschend, daß gleichzeitig ein Strahlen der Oberfläche durch CO₂ stattfindet, wodurch erreicht wird, daß eine Einbettung stark oxidierter, störender Kleinstpartikel in die Beschichtung unterbunden wird.

Nach dem erfindungsgemäßen Verfahren aufgetragene Kupferschichten können eine Schichtdicke im Bereich von 5 bis 300 µm aufweisen, wobei die Dickengleichmäßigkeit bei dünneren Schichten um ca. 20 % und bei dickeren Schichten nur noch um 5 % schwankt. Die Haftfestigkeit der Schichten, die durch Stirnabzug in Anlehnung an DIN 50 160 gemessen wird, liegt im Bereich von 3 bis 10 MPa. Um die Haftfestigkeit der aufgetragenen Schichten weiter zu verbessern, ist im Rahmen der vorliegenden Erfindung eine zusätzliche Wärmenachbehandlung vorgesehen. Die Wärmenachbehandlung wird in einem Durchlaufofen mit verschiedenen Heizzonen bei Temperaturen von 600 bis 800 °C durchgeführt und erstreckt sich über eine Zeitdauer von wenigstens 5 min, vorzugsweise - bei dickeren Schichten - wenigstens 10 min. Die Wärmebehandlung wird in Gegenwart einer reduzierenden Atmosphäre oder im Vakuum durchgeführt, wobei als reduzierende Atmosphäre ein Gemisch von 95 % Argon und 5 % Wasserstoff besonders geeignet ist. Die elektrische Leitfähigkeit der so hergestellten Schichten liegt typischerweise im Bereich von 30 bis 57 m/Ω·mm², vorzugsweise von 40 bis 57 m/Ω·mm².

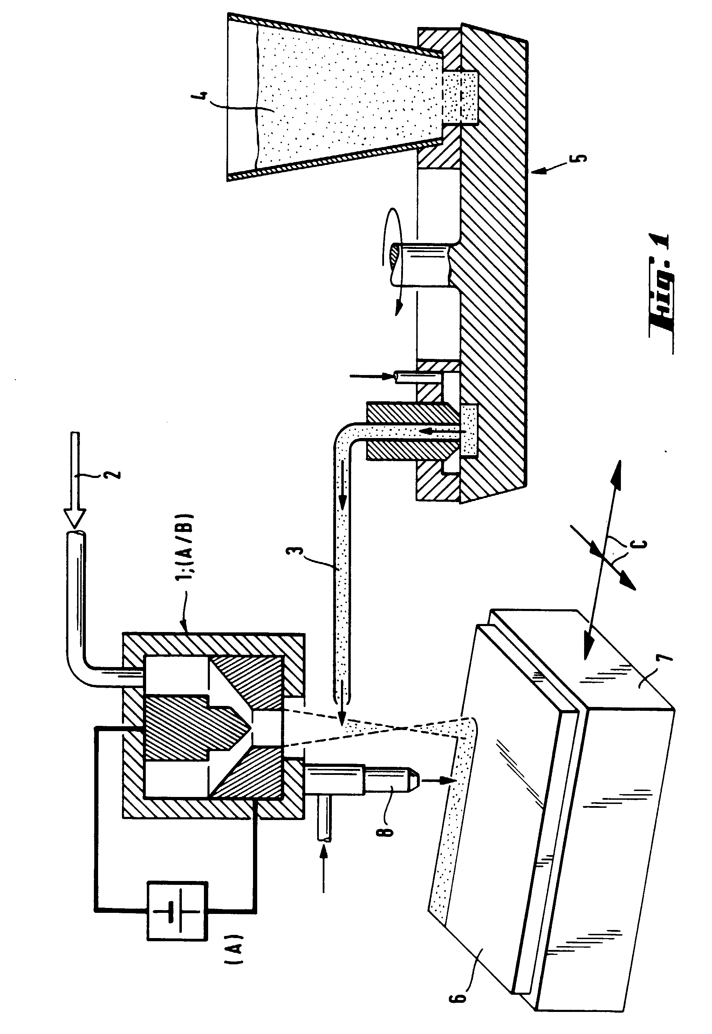

Die Figur 1 zeigt eine schematische Darstellung, nach der das erfindungsgemäße Beschichtungsverfahren durchgeführt werden kann. Im einzelnen sind mit Bezugszeichen der Plasmabrenner 1 dargestellt, in den das Plasmagas 2 eingeleitet wird. Das Kupferpulver 4 wird in einer Dosiervorrichtung 5 vorgelegt, zusammen mit einem Pulverträgergas über eine Zuführung 3 in den heißen Gasstrahl eingegeben und schlägt sich dann auf der Keramikplatte 6 nieder. Die Keramikplatte 6 ist auf einer in den Bewegungsrichtungen C beweglichen Vorschubeinrichtung 7 montiert und wird mit der Kohlensäurekühlung 8 gekühlt. Die dargestellte Apparatur kann wahlweise zum Plasmaspritzen A oder zum Hochgeschwindigkeitsflammspritzen B eingesetzt werden.

Überraschend zeigte sich, daß sich die nach dem erfindungsgemäßen Herstellungsverfahren erhaltenen beschichteten Keramikbauteile besonders gut für die Verwendung zur fotolithographischen Strukturierung von elektrischen Leiterbahnen eigenen, wobei derartige Leiterbahnen insbesondere eine elektrische Leitfähigkeit von wenigstens 30 m/Ω·m² und eine Haftfestigkeit von wenigstens 20 MPa besitzen und vorteilhafterweise ohne Flußmittel maschinell verlötet werden können.

Die Erfindung soll nachfolgend anhand der Ausführungsbeispiele näher beschrieben werden, ohne aber auf die konkret beschriebenen Ausführungsformen beschränkt zu sein.

### Beispiel 1

Mit einem Gemisch von Schwefelsäure und Phosphorsäure (Mischungsverhältnis 1 : 1) wurde eine Aluminiumoxidplatte bei einer Temperatur von 240 °C über eine Zeitdauer von 45 Minuten aufgerauht. Die Platte besaß eine geometrische Abmessung von 100 x 100 mm Kantenlänge und eine Dicke von 0,6 mm und wurde mit einer Plasmaspritzeinrichtung gemäß Figur 1 beschichtet, nachdem sie mit Wasser gepült und bei 200 °C über eine Zeitdauer von 40 Stunden im Ofen getrocknet wurde. Die Platte hatte danach eine Oberflächenrauhigkeit R_{z} (DIN 4768) von 3,5 µm. Die Platte wurde mit einem Kupferpulver mit einer Korngröße d₅₀ von 8 bis 10 µm nach dem Plasmaspritzverfahren beschichtet. Als Plasmagas wurde Argon verwendet in einer Menge von 40 l/min. Die Brennerleistung betrug 12 kW und der Brenner wurde in einem Abstand von 60 mm mit einer Geschwindigkeit von 40 m/min über die Platte bewegt. Als Kühlung wurde CO₂ flüssig aus zwei Düsen unter einem Druck von 60 bar aufgesprüht.

Die so hergestellte Kupferschicht hatte eine Schichtdicke von 75 µm und eine Oberflächenrauhigkeit R_{z} von 8 bis 10 µm (DIN 4768). Ihre elektrische Leitfähigkeit betrug 6 m/Ω·mm², die Haftfestigkeit wurde mit 5 MPa gemessen. Die beschichte Platte wurde sodann einer Wärmenachbehandlung in einem Mehrzonendurchlaufofen bei Temperaturen von 600 und 800 °C über eine Zeitdauer von 10 min unter einer Atmosphäre mit 95 % Argon und 5 % Wasserstoff unterzogen. Danach betrug die Leitfähigkeit der Kupferschicht 35 m/Ω·mm², die Haftfestigkeit betrug 30 MPa.

### Beispiel 2

Eine Aluminiumoxidplatte wie in Beispiel 1 wurde unter gleichen Bedingungen wie in Beispiel 1 mit einer Kupferschicht überzogen, die jedoch nur eine Dicke von 30 µm besaß. Nach einer Wärmenachbehandlung unter gleichen Bedingungen wie in Beispiel 1 wurde die Leitfähigkeit der aufgetragenen Kupferschicht gemessen und ergab einen Wert von 45 m/Ω·mm², die Haftfestigkeit betrug 31 MPa.

### Vergleichsbeispiel:

Eine in gleicher Weise wie in Beispiel 1 vorbehandelte Aluminiumoxidplatte wurde mit einem herkömmlichen Kupferpulver einer mittleren Korngröße im Bereich von 40 bis 80 µm nach dem Plasmaspritzverfahren beschichtet. Bei dem Plasmaspritzen wurde eine Auftragsrate von 7 kg/h bei einer Brennerleistung von 27 KW eingestellt. Als Plasmagas wurde ein Gemisch aus Stickstoff und Wasserstoff mit einem Mischungsverhältnis von 15 : 1 eingesetzt. Der Abstand des Brenners zum Werkstück betrug 125 mm.

20 % der beschichteten Platten wurden durch den heißen Gasstrahl infolge zu großer Wärmeentwicklung zerstört. Die nach dem Vergleichsbeispiel hergestellte Kupferschicht ergab eine Oberflächenstruktur, die eine Rauhigkeit R_{z} von mehr als 30 µm aufwies. Die Messung der elektrischen Leitfähigkeit ergab einen Wert von weniger als 5 m/Ω·mm².

## Patentansprüche

1. Verfahren zur Herstellung eines haftfesten Verbundes zwischen Kupferschichten, die mittels thermischer Spritztechnik von pulverförmigem Kupfer oder Kupferlegierungen aufgebracht sind, und Keramik, dadurch gekennzeichnet, daß auf die keramische Oberfläche feinkörniges Pulver aus Kupfer oder Kupferlegierungen mit einem mittleren Teilchendurchmesser von ≤ 20 µm durch thermisches Spritzen aufgetragen wird.

2. Verfahren nach Anspruch 1, dadurch gekennzeichnet, daß als keramisches Material vorzugsweise oxidkeramisches Material wie Aluminiumoxid, Berylliumoxid oder Zirkoniumoxid oder nichtoxidkeramisches Material wie Aluminiumnitrid verwendet wird.

3. Verfahren nach Anspruch 1 oder 2, dadurch gekennzeichnet, daß die keramische Oberfläche zunächst einem Aufrauhprozeß, vorzugsweise mit Mineralsäuren, unterzogen und anschließend gereinigt und bei Temperaturen von wenigstens 180 °C über eine Zeitdauer von wenigstens 24 Stunden getrocknet wird.

4. Verfahren nach einem der Ansprüche 1 bis 3, dadurch gekennzeichnet, daß als thermisches Spritzen das Plasmaspritzen oder das Hochgeschwindigkeitsflammspritzen verwendet wird.

5. Verfahren nach einem der Ansprüche 1 bis 4, dadurch gekennzeichnet, daß das Pulver aus Kupfer oder einer Kupferlegierung eine Korngröße d₅₀ im Bereich von 8 bis 12 µm besitzt, wobei dem Kupfer als Legierungsbestandteile Edelmetalle wie Silber, Gold oder Palladium in Mengen bis zu 30 % zulegiert sein können.

6. Verfahren nach einem der Ansprüche 1 bis 5, dadurch gekennzeichnet, daß das Kupferpulver eine Reinheit von mindestens 99 % aufweist, wobei sein Phosphorgehalt im Bereich von 0,08 bis 0,15 % liegt und wobei sein Sauerstoffgehalt im Bereich von 0,2 bis 0,3 % liegt.

7. Verfahren nach einem der Ansprüche 1 bis 6, dadurch gekennzeichnet, daß die beschichtete Keramik zusätzlich einer Wärmenachbehandlung in einer reduzierenden Atmosphäre oder im Vakuum bei Temperaturen im Bereich von 600 bis 800 °C über eine Zeitdauer von wenigstens 5 min unterzogen wird.

8. Verfahren nach einem der Ansprüche 1 bis 7, dadurch gekennzeichnet, daß die zur Beschichtung vorgesehene Keramik während des Beschichtungsvorganges gekühlt wird.

9. Verfahren nach Anspruch 8, dadurch gekennzeichnet, daß zur Kühlung CO₂ in fein kristalliner oder flüssiger Form bei hohem Druck im Bereich von 40 bis 60 bar eingesetzt wird.

10. Mit Kupfer oder einer Kupferlegierung beschichtetes keramisches Bauteil, hergestellt nach einem Verfahren gemäß einem der Ansprüche 1 bis 9, dadurch gekennzeichnet, daß die Beschichtung eine Oberflächenrauhigkeit R_{z} im Bereich von ≤ 10 µm besitzt.

11. Verwendung eines Bauteils nach Anspruch 10, hergestellt nach einem Verfahren nach einem der Ansprüche 1 bis 9 zur fotolithographischen Strukturierung von elektrischen Leiterbahnen.

12. Verwendung eines mit Kupfer beschichteten keramischen Bauteils hergestellt nach einem Verfahren nach einem der Ansprüche 7 bis 9 zur fotolithographischen Strukturierung von elektrischen Leiterbahnen, die eine elektrische Leitfähigkeit von wenigstens 30 m/Ω·m² und eine Haftfestigkeit von wenigstens 20 MPa besitzen.

## Claims

1. A process for producing an adhesive bond between copper layers, which have been applied by means of thermal spraying of pulverulent copper or copper alloys, and ceramic, which comprises applying fine powder of copper or copper alloys having a mean particle diameter of ≤ 20 µm to the ceramic surface by thermal spraying.

2. The process as claimed in claim 1, wherein the ceramic material used is preferably oxide ceramic material such as aluminum oxide, beryllium oxide or zirconium oxide or nonoxidic ceramic material such as aluminum nitride.

3. The process as claimed in claim 1 or 2, wherein the ceramic surface is first subjected to a roughening process, preferably using mineral acids, and is subsequently cleaned and dried at temperatures of at least 180°C for a period of at least 24 hours.

4. The process as claimed in any one of claims 1 to 3, wherein the thermal spraying method used is plasma spraying or high-speed flame spraying.

5. The process as claimed in any one of claims 1 to 4, wherein the powder of copper or a copper alloy has a particle size d₅₀ in the range from 8 to 12 µm, and noble metals such as silver, gold or palladium in amounts of up to 30% can be alloyed with the copper as alloy constituents.

6. The process as claimed in any one of claims 1 to 5, wherein the copper powder has a purity of at least 99%, with its phosphorus content being in the range from 0.08 to 0.15% and its oxygen content being in the range from 0.2 to 0.3%.

7. The process as claimed in any one of claims 1 to 6, wherein the coated ceramic is additionally subjected to subsequent heat treatment in a reducing atmosphere or in vacuo at temperatures in the range from 600 to 800°C over a period of at least 5 minutes.

8. The process as claimed in any one of claims 1 to 7, wherein the ceramic to be coated is cooled during the coating process.

9. The process as claimed in claim 8, wherein cooling is carried out using CO₂ in finely crystalline or liquid form at high pressure in the range from 40 to 60 bar.

10. A ceramic component coated with copper or a copper alloy, produced by a process as claimed in any one of claims 1 to 9, wherein the coating has a surface roughness R_{z} in the range ≤ 10 µm.

11. Use of a component as claimed in claim 10, produced by a process as claimed in any one of claims 1 to 9, for photolithographic structuring of electrical strip conductors.

12. Use of a ceramic component coated with copper and produced by a process as claimed in any one of claims 7 to 9 for photolithographic structuring of electrical strip conductors which have electrical conductivity of at least 30 m/Ω·mm² and an adhesive strength of at least 20 MPa.

## Revendications

1. Procédé pour fabriquer un composite adhérent entre des couches de cuivre, appliquées par une technique de pulvérisation thermique de cuivre ou d'alliages de cuivre en poudre, et céramique, caractérisé en ce qu'on applique sur la surface céramique, par pulvérisation thermique, une poudre à fine granulométrie de cuivre ou d'alliages de cuivre ayant une granulométrie moyenne ≤ 20 µm.

2. Procédé selon la revendication 1, caractérisé en ce qu'on utilise en tant que matériau céramique de préférence un matériau céramique à base d'oxydes tel que l'oxyde d'aluminium, l'oxyde de béryllium ou l'oxyde de zirconium, ou un matériau céramique qui n'est pas à base d'oxydes, tel que le nitrure d'aluminium.

3. Procédé selon la revendication 1 ou 2, caractérisé en ce que la surface céramique est soumise d'abord à une opération de grattage, de préférence avec des acides minéraux, puis est nettoyée et est séchée pendant au moins 24 heures à des températures d'au moins 180°C.

4. Procédé selon l'une des revendications 1 à 3, caractérisé en ce qu'on utilise en tant que pulvérisation thermique la pulvérisation par plasma ou la pulvérisation à la flamme à grande vitesse.

5. Procédé selon l'une des revendications 1 à 4, caractérisé en ce que la poudre de cuivre ou d'un alliage de cuivre a une granulométrie d₅₀ comprise entre 8 et 12 µm, auquel cas on peut allier au cuivre, en tant que constituants d'alliage, des métaux précieux tels que l'argent, l'or ou le palladium, en des quantités allant jusqu'à 30 %.

6. Procédé selon l'une des revendications 1 à 5, caractérisé en ce que la poudre de cuivre a une pureté d'au moins 99 %, sa teneur en phosphore étant de 0,08 à 0,15 % et sa teneur en oxygène étant comprise entre 0,2 et 0,3 %.

7. Procédé selon l'une des revendications 1 à 6, caractérisé en ce que la céramique revêtue est en outre soumise à un post-traitement thermique dans une atmosphère réductrice ou sous vide à des températures comprises entre 600 et 800°C et pendant un laps de temps d'au moins 5 min.

8. Procédé selon l'une des revendications 1 à 7, caractérisé en ce que la céramique prévue pour le revêtement est refroidie pendant l'opération de revêtement.

9. Procédé selon la revendication 8, caractérisé en ce qu'on utilise pour le refroidissement du CO₂ sous une forme finement cristalline ou liquide, sous une haute pression comprise entre 40 et 60 bar.

10. Pièce céramique revêtue de cuivre ou d'un alliage de cuivre, fabriquée par un procédé selon l'une des revendications 1 à 9, caractérisée en ce que le revêtement présente une rugosité de surface R_{z} ≤ 10 µm.

11. Utilisation d'une pièce selon la revendication 10, fabriquée par un procédé selon l'une des revendications 1 à 9, pour la structuration photolithographique de pistes conductrices de l'électricité.

12. Utilisation d'une pièce céramique revêtue de cuivre, fabriquée par un procédé selon l'une des revendications 7 à 9, pour la structuration photolithographique de pistes conductrices électriques présentant une conductivité électrique d'au moins 30 m/Ω.mm² et une force d'adhérence d'au moins 20 MPa.
